# EUROPEAN PATENT SPECIFICATION

(11) **EP 4 052 074 B1**
(45) Date of publication and mention of the grant of the patent: **31.07.2024**
(21) Application number: 19953010.6
(22) Date of filing: 21.11.2019
(51) Int. Cl.: G02B 5/20

(54) **WAVELENGTH SELECTIVE FILTER AND METHOD FOR FABRICATING WAVELENGTH SELECTIVE FILTER**
WELLENLÄNGENSELEKTIVER FILTER UND VERFAHREN ZUR HERSTELLUNG EINES WELLENLÄNGENSELEKTIVEN FILTERS
FILTRE SÉLECTIF EN LONGUEUR D'ONDE ET PROCÉDÉ PERMETTANT DE FABRIQUER UN FILTRE SÉLECTIF EN LONGUEUR D'ONDE

(43) Date of publication of application: 07.09.2022
(73) Proprietor: Huawei Technologies Co., Ltd., Shenzhen, Guangdong 518129 (CN); Tohoku University, Sendai-shi, Miyagi 980-8577 (JP)
(72) Inventor: NIHEI, Mizuhisa, Yokohama, Kanagawa 221-0056 (JP); YU, Feng, Yokohama, Kanagawa 221-0056 (JP); KANAMORI, Yoshiaki, Sendai, Miyagi 980-8577 (JP)
(74) Representative: Thun, Clemens
(86) International application number: PCT/CN2019/120038
(87) International publication number: WO 2021/097773

(56) References cited:
- WO-A1-2009/011439
- WO-A1-2017/135430
- WO-A1-2018/223874
- CN-A- 101 730 857
- CN-A- 103 245 996
- CN-A- 103 245 996
- CN-A- 104 570 184
- CN-A- 104 570 184
- CN-A- 108 469 645
- CN-A- 109 031 493
- CN-A- 110 320 670
- US-A1- 2010 046 077
- US-A1- 2013 301 988

## Description

### TECHNICAL FIELD

This disclosure relates filter technical field. Especially, this disclosure relates to a wavelength selective filter and a method for fabricating a wavelength selective filter.

### BACKGROUND

As a wavelength selective filter for obtaining transmitted light with a certain wavelength range from incident light including various wavelength, a wavelength selective filter using dye material, a wavelength selective filter using a multi-layer film of dielectric material, and a wavelength selective filter utilizing surface plasmon resonance are known.

A wavelength selective filter using a dye material has a problem wherein the durability thereof is not high because the dye deteriorates due to UV light. A wavelength selective filter using a multi-layer film of dielectric material has a problem wherein the manufacturing cost tends to be high because many thin films should be laminated in order to achieve high performance.

A wavelength selective filter utilizing surface plasmon resonance has a periodic structure made of metal or semiconductor and utilizes surface plasmon resonance generated at the interface between the metal or the semiconductor and dielectric material (Patent Literature 1). Compared to the wavelength selective filter using dye material and the wavelength selective filter using a multi-layer film of dielectric material, the wavelength selective filter utilizing surface plasmon resonance is advantageous because the fabrication process thereof is easy, the manufacturing cost thereof is low, and it is easy to fabricate filters with different transmission wavelength ranges on the same substrate.

### [Patent Literature 1] JP2007-41555A

Further examples of a wavelength selective filter utilizing surface plasmon resonance are disclosed in CN 104 570 184 A, WO 2018/223874 A1 and WO 2009/011439 A1.

### SUMMARY

As explained above, the wavelength selective filter utilizing surface plasmon resonance is advantageous because the fabrication process thereof is easy and the manufacturing cost thereof is low, however, it has a problem wherein the full width at half maximum of the transmission light is relatively broad. A wavelength selective filter utilizing surface plasmon resonance that can provide transmission light with narrower full width at half maximum than conventional filters is desired, for example for an application such as a spectroscopic sensor loaded onto smartphones, sensors, IOT devices, and so on, a hyperspectral imaging camera, or an optical camera. From a standpoint of its application, a wavelength selective filter having a peak wavelength between 750 nm and 1050 nm is desired.

The present disclosure was invented in view of the aforementioned problems, and the purpose of the present application includes providing a wavelength selective filter utilizing surface plasmon resonance wherein the wavelength selective filter has a peak wavelength in a near infrared wavelength region, and wherein the wavelength selective filter has a narrower full width at half maximum of the transmission light than a conventional filter, and providing a method for fabricating the wavelength selective filter.

The present disclosure provides a wavelength selective filter, which performance could be improved by combining a periodic structure made of metal or semiconductor and a predetermined multi-layered structure. And the present application employs the following aspects.
(1) A wavelength selective filter according to the first aspect comprises a multi-layered structure alternately having a low refractive index layer and a high refractive index layer, a periodic structure layer facing the low refractive index layer of the multi-layered structure, the low refractive index layer having a refractive index between 1.30 and 1.60 and a thickness between 100 nm and 800 nm, the high refractive index layer having a refractive index between 1.70 and 2.20 and a thickness between 30 nm and 100 nm, and in a plane perpendicular to a thickness direction of the periodic structure layer, the periodic structure layer having a periodic structure made of metal or a semiconductor. In the plane perpendicular to the thickness direction of the periodic structure layer, the periodic structure is surrounded by first material having a refractive index between 1.30 and 1.60, wherein the wavelength selective filter has second material between two neighbouring first materials, and wherein the second material has a refractive index between 1.00 and 1.20.

The wavelength selective filter according to this aspect realizes desirable surface plasmon resonance thanks to a combination of a certain multi-layered structure and a periodic structure layer. As a result, the wavelength selective filter according to this aspect can provide a peak wavelength in a near infrared wavelength region and a narrower full width at half maximum (FWHM) of the transmission wavelength than that of a conventional filter.

Further in this aspect, the durability of the wavelength selective filter improves because the first material protects the periodic structure from metal oxidation and the like by the moisture in the atmosphere. In addition, by using the first material having a certain refractive index, it is possible to improve the durability of the wavelength selective filter without degrading the performance of the wavelength selective filter. Further, the second material affects the surface plasmon resonance, and accordingly, the resolution of the wavelength selective filter improves.

(2) In the wavelength selective filter according to aforementioned aspects, the multi-layered structure may be a three-layered structure consisting of two low refractive index layers and one high refractive index layer positioned between the two low refractive index layers.

In this aspect, the multi-layered structure has sufficient configuration to realize narrow FWHM of the transmission light while the multi-layered structure does not block the light transmission too much. As a result, it is possible to realize both narrow FWHM of the transmission light and high transmittance.

(3) In the wavelength selective filter according to aforementioned aspects, the periodic structure may be composed of a plurality of square island structures that are arranged spaced apart in a grid pattern, and length of one side of the square island structure may be between 65% and 85% of an arrangement pitch of the square island structure.

In this aspect, by using the square island structure having a certain size relative to the arrangement pitch, preferable surface plasmon resonance is realized. As a result, high transmittance can be obtained.

(4) A method for fabricating the wavelength selective filter according to the second aspect comprises steps of: alternately depositing the low refractive index layer and the high refractive index layer to form the multi-layered structure; depositing a layer of the metal or the semiconductor; patterning the layer of the metal or the semiconductor to form the periodic structure, and depositing the layer made of the first material with a desired thickness.

The wavelength selective filter produced by this aspect can realize desirable surface plasmon resonance by combining a certain multi-layered structure and a periodic structure layer. As a result, it is possible to realize an advantageous effect wherein desirable surface plasmon resonance is realized.

### BRIEF DESCRIPTION OF DRAWINGS

FIG. 1 is a cross sectional schematic diagram of a wavelength selective filter according to a first example placed on a substrate (100).
FIG. 2 is a schematic top view of a wavelength selective filter according to the first example and an illustrative scanning electron microscope (SEM) image of a wavelength selective filter according to the present embodiment.
FIG. 3 is a cross sectional schematic diagram of a wavelength selective filter according to a second example.
FIG. 4 is a cross sectional schematic diagram of a wavelength selective filter according to a preferable embodiment.
FIG. 5 is a cross sectional schematic diagram of a wavelength selective filter according to a preferable embodiment.
FIG. 6 is a cross sectional schematic diagram of a wavelength selective filter according to another example with an image sensor (110).
FIG. 7 is simulation results of the transmission light of the wavelength selective filter according to the configuration described in Figure 5.
FIG. 8 is fabrication flow of the wavelength selective filter according to the present embodiment.
FIG. 9 is measurement results of transmittance of the wavelength selective filters fabricated in the examples.

### DESCRIPTION OF EMBODIMENTS

In the following, the present embodiment will be described in detail with reference to the drawings. The drawings used in the following description may show enlarged features for convenience for the sake of easy understanding of the features of the present disclosure, and the dimensional ratio of each component may be different from the actual one. The materials, dimensions, and the like exemplified in the following description are merely examples, and the present disclosure is not limited to them. The present disclosure can be implemented with appropriate modifications without departing from the gist of the present disclosure.

### [Wavelength Selective Filter]

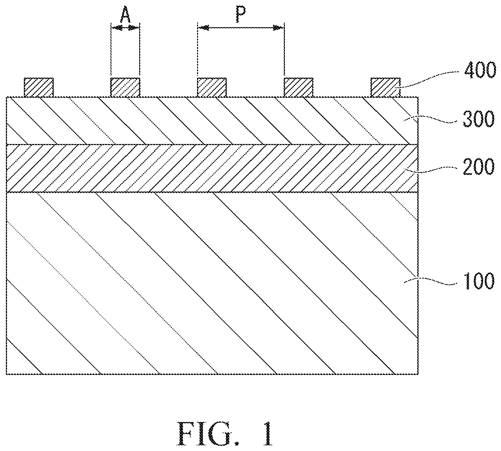

Figure 1 shows a cross sectional schematic diagram of a wavelength selective filter according to a first example placed on a substrate (100). The wavelength selective filter comprises a multi-layered structure alternately having a low refractive index layer (300) and a high refractive index layer (200) and a periodic structure layer facing the low refractive index layer (300) of the multi-layered structure. In a plane perpendicular to a thickness direction of the periodic structure layer, the multi-layered structure layer has a periodic structure (400) made of metal or semiconductor.

### <Multi-Layered Structure>

The multi-layered structure according to the present embodiment has a low refractive index layer (300) and a high refractive index layer (200), alternately. In the wavelength selective filter according to the present embodiment, the multi-layered structure affects the surface plasmon resonance derived from the periodic structure (400). By employing a configuration of a predetermined multi-layered structure, transmission light spectrum with a narrower full width at half maximum than conventional filters can be obtained. Surface plasmon resonance is affected by the structure in the direction of the thickness of the filter as well as by the structure of the periodic structure layer in the direction perpendicular to the thickness of the filter (in-plane direction). Therefore, by modifying the configuration of the multi-layered structure, surface plasmon resonance is affected. As a result, it is possible to adjust the FWHM of the transmission light.

The number of the layers of the multi-layered structure is not limited, and the multi-layered structure may have at least one low refractive index layer (300) and at least one high refractive index layer (200). However, the number of the layers of the multi-layered structure is preferably 10 or less, more preferably 5 or less, and more preferably 3 or less because the transmittance gets low when the multi-layered structure has a lot of layers. When the number of the layers of the multi-layered structure is 10 or less, a narrow full width at half maximum of the transmission light and high transmittance can be achieved. By not using too many layers in the multi-layered structure, the multi-layered structure does not block the light transmission too much, and accordingly, high transmittance is realized. Also, by using a multi-layer comprising two or more layers, narrow FWHM of the transmission light is realized.

In particular, the multi-layered structure is preferably a three-layered structure consisting of two low refractive index layers (300) and one high refractive index layer (200) positioned between the two low refractive index layers (300).

### (Low Refractive Index Layer)

The low refractive index layer (300) according to the present embodiment has a refractive index between 1.30 and 1.60 and a thickness between 100 nm and 800 nm. In the present application, "refractive index" may mean a refractive index to the light with a wavelength between 750 nm and 1050 nm, for example, may mean a refractive index to the light with a wavelength of 900 nm. By employing the low refractive index layer (300) with the refractive index and the thickness in this range, transmission light with a narrow full width at half maximum and high transmittance can be obtained.

The refractive index of the low refractive index layer (300) is preferably between 1.40 and 1.55. The thickness of the low refractive index layer (300) is preferably between 100 nm and 300 nm, is more preferably between 170 nm and 190 nm, and is more preferably between 178 nm and 182 nm.

The material of the low refractive index layer (300) is not limited as long as the above refractive index is satisfied. Inorganic material may be used as the material of the low refractive index layer (300), and organic material such as polymers may be used as the material of the low refractive index layer (300). It is preferable to use inorganic material as the material of the low refractive index layer (300), and it is more preferable to use inorganic insulating material. By using inorganic material as the material of the low refractive index layer (300), it is possible to improve the durability of the wavelength selective filter.

For example, as the material of the low refractive index layer (300), it is possible to use fluorides such as magnesium fluoride (MgF2) and calcium fluoride (CaF2), and oxides such as silicon dioxide (SiO2). It is preferable to use silicon dioxide as the material of the low refractive index layer (300).

### (High Refractive Index Layer)

The high refractive index layer (200) according to the present embodiment has a refractive index between 1.70 and 2.20 and a thickness between 30 nm and 100 nm. By employing the high refractive index layer (200) with the refractive index and the thickness in this range, transmission light with narrow full width at half maximum and high transmittance can be obtained.

The refractive index of the high refractive index layer (200) is preferably between 1.90 and 2.10, and is more preferably between 1.90 and 2.00. The thickness of the high refractive index layer (200) is preferably between 60 nm and 100 nm, is more preferably between 70 nm and 90 nm, and is more preferably between 78 nm and 82 nm.

The material of the high refractive index layer (200) is not limited as long as the above refractive index is satisfied. Inorganic material may be used as the material of the high refractive index layer (200), and organic material such as polymers may be used as the material of the high refractive index layer (200). It is preferable to use inorganic material as the material of the high refractive index layer (200), and it is more preferable to use inorganic insulating material. By using inorganic material as the material of the high refractive index layer (200), it is possible to improve the durability of the wavelength selective filter.

For example, as the material of the high refractive index layer (200), it is possible to use oxides such as magnesium oxide (MgO), aluminium oxide (Al2O3), zinc oxide (ZnO), and hafnium oxide (HfO2). It is preferable to use hafnium oxide as the material of the high refractive index layer (200).

### <Periodic Structure Layer>

The periodic structure layer according to the present embodiment faces the low refractive index layer (300) of the multi-layered structure. In a plane perpendicular to a thickness direction of the low refractive index layer (300), the multi-layered structure layer has a periodic structure (400) made of metal or semiconductor. The periodic structure (400) is formed by periodically arranging many structural objects made of metal or semiconductor. The many structural objects are arranged in a N*M array, and the distance between every two structural objects is same. Especially, the smallest distance between every two structural objects in the N*M array is same. Surface plasmon resonance arises due to the periodic structure (400).

In the periodic structure (400), a width (A) of the structural object made of metal or semiconductor and an arrangement pitch (P) of the structural object made of metal or semiconductor may be appropriately selected according to the desired transmission wavelength. The width (A) is defined as a value obtained by subtracting the minimum clearance between the structural objects from the arrangement pitch (P). The arrangement pitch (P) is a repetition distance of the structural objects in the direction in which the clearance between the structural objects is minimum. It should be noted that extending direction of the width (A) of the structure object and extending direction of the arrangement pitch (P) of the structure object are same. For example, the arrangement pitch (P) may be between 100 nm and 1500 nm, and is preferably between 400 nm and 800nm. The thickness (height) of the structural object made of metal or semiconductor may be between 20 nm and 80 nm, is preferably between 20 nm and 40 nm, and is more preferably between 28 nm and 32 nm.

The periodic structure (400) may be formed from any metal or semiconductor that can provide the effect of surface plasmon resonance. For example, the periodic structure (400) may be formed from metal alone such as Al, Au, Ag, Cu, Mg, Zr, In, Sn, Fe, Co, Ni, Rh, Ir and Pr, or from an alloy thereof. The periodic structure (400) may be formed from a conducting oxide such as ITO (Indium Tin Oxide) and zinc oxide. The periodic structure (400) is preferably formed from Al, Au, or the alloy thereof because they can show high surface plasmon resonance effect. It is particularly preferable to form the periodic structure (400) from Al.

The periodic structure (400) may be any periodic structure that can cause surface plasmon resonance, and may be a structure such as square grid shape, triangle grid shape or stripe shape. In a plane perpendicular to a thickness direction of the periodic structure layer, the shape of the structural object constituting the periodic structure layer (400) may be any shape such as circular, elliptical, polygonal, equilateral triangle, square or regular hexagon. The property of the wavelength selective filter may be controlled by the shape of the structural object. In general, (i) the selected wavelength can be determined by the pitch and the size of the structural objects; (ii) the transmittance improves when the surface coverage by the structural objects is low; (iii) the resolution of the wavelength selective filter improves when the refractive index difference in the multi-layered structure is large; and (iv) the resolution of the wavelength selective filter improves as the multi-layered structure comprises more layers, whereas the transmittance decreases as the multi-layered structure comprises more layers.

The periodic structure (400) is preferably composed of a plurality of square island structures that are arranged spaced apart in a grid pattern, and width (A) of one side of the square island structure is preferably between 65% and 85% of an arrangement pitch (P) of the square island structure. The width (A) of one side of the square island structure is more preferably between 70% and 80% of the arrangement pitch (P) of the square island structure. Preferable surface plasmon resonance can be realized and high transmittance can be obtained by employing a predetermined size ratio of the square island structure to the arrangement pitch.

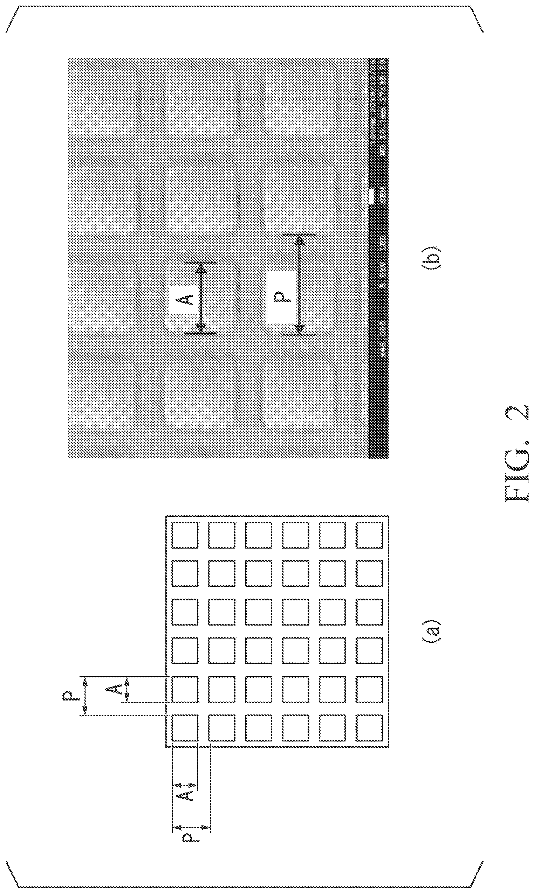

Figure 2 (a) shows a schematic top view of a wavelength selective filter according to a second example. The periodic structure (400) composed of a plurality of square island structures that are arranged spaced apart in a grid pattern is arranged on the multi-layered structure. Figure 2 (b) shows an illustrative scanning electron microscope (SEM) image of a wavelength selective filter according to the present example.

The periodic structure (400) may have a plurality of areas that have different width (A) and/or arrangement pitch (P) on the same multi-layered structure. It should be noted that structural objects in the same area have same shapes, and every two of the arrangement pitches in the same area are same. The plurality of areas that have different width (A) and/or arrangement pitch (P) selectively pass light with different wavelength. An area that selectively passes a certain wavelength forms a pixel.

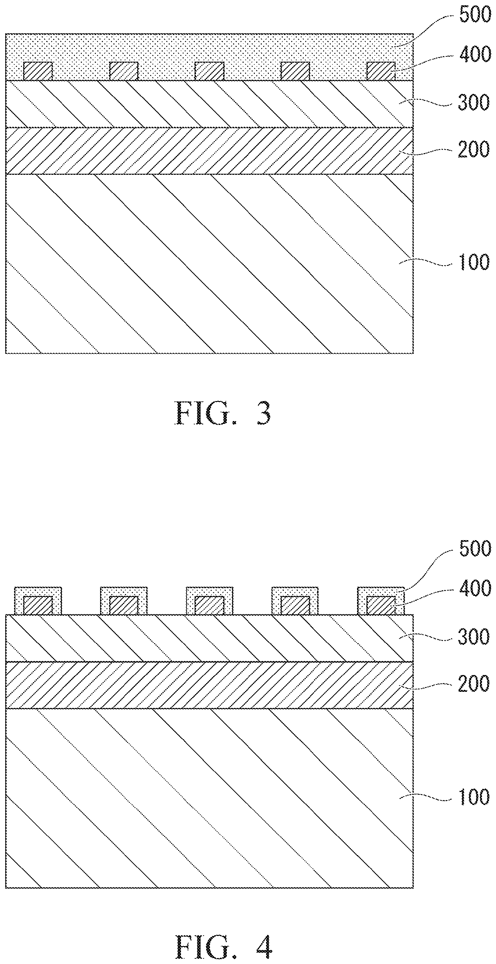

In a plane perpendicular to the thickness direction of the periodic structure layer, the periodic structure (400) is preferably surrounded by first material having a refractive index between 1.30 and 1.60. Figure 3 shows a cross sectional schematic diagram of a wavelength selective filter according to a further example. In the example shown in Figure 3, in the plane perpendicular to the thickness direction of the periodic structure layer, the periodic structure (400) is surrounded by first material (500). By this configuration, the durability of the wavelength selective filter improves because the periodic structure (400) can be protected from metal oxidation and the like by the moisture in the atmosphere. By using the first material (500) having a refractive index within the aforementioned range, it is possible to improve the durability of the wavelength selective filter without degrading the performance of the wavelength selective filter.

The refractive index of the first material (500) is preferably between 1.40 and 1.55. The material of the first material (500) is not limited as long as the refractive index is within the above range. Inorganic material may be used as the material of the first material (500), and organic material such as polymers may be used as the material of the first material (500). It is preferable to use inorganic material as the material of the first material (500), and it is more preferable to use inorganic insulating material. By using inorganic material as the material of the first material (500), it is possible to improve the durability of the wavelength selective filter.

For example, as the first material (500), it is possible to use fluorides such as magnesium fluoride (MgF2) and calcium fluoride (CaF2), and oxides such as silicon dioxide (SiO2). It is preferable to use silicon dioxide as the first material (500). The first material (500) and the material of the low refractive index layer (300) may be the same and may be different. Preferably, the first material (500) and the material of the low refractive index layer (300) are the same.

The periodic structure (400) is embedded in a layer made of the first material (500). An example of a wavelength selective filter according to a further example is shown in Figure 3. In this case, the durability of the wavelength selective filter particularly improves. In the present application, "the periodic structure (400) is embedded in a layer made of the first material (500)" means that the thickness of the layer made of the first material (500) is larger than the thickness of the periodic structure (400) and the periodic structure (400) exists inside the layer made of the first material (500).

When the periodic structure (400) is embedded in the layer made of the first material (500), surface of the layer made of the first material (500) opposite the multi-layered structure is preferably flat. In other words, the arithmetic mean estimation (Ra) of the surface is preferably 10 nm or less, more preferably 3 nm or less, and more preferably 1 nm or less. When the surface of the layer made of the first material (500) opposite the multi-layered structure is flat, it becomes easy to mount an on-chip lens on the surface of the layer made of the first material (500) opposite the multi-layered structure. Incident angle of the transmission light to the image sensor can be controlled by mounting the on-chip lens. As a result, the detection sensitivity and/or the wavelength resolution of the image sensor improves.

In another preferable embodiment, in the plane perpendicular to the thickness direction of the periodic structure layer, the wavelength selective filter may have second material between two neighbouring first materials (500), wherein the second material has a refractive index between 1.00 and 1.20. A cross sectional schematic diagram of a wavelength selective filter according to the preferable embodiment is shown in Figure 4. In the wavelength selective filter according to the present embodiment, the periodic structure (400) is covered with a thin layer (thin film) made of the first material (500). The second material may be any gas and is preferably air.

When the second material with lower refractive index than the refractive index of the first material (500) exists between the first materials (500) surrounding the periodic structure (400), the resolution of the wavelength selective filter improves. The refractive index of the second material is preferably between 1.00 and 1.10, and is more preferably between 1.00 and 1.05.

In the embodiment shown in Figure 4, the thickness of the layer made of the first material (500) may be between 1 nm and 50 nm, and is preferably between 20 nm and 40 nm, and is more preferably between 28 nm and 32 nm. By employing the thickness within this range, it is possible to obtain the transmission light with narrow full width at half maximum while sufficiently protecting the periodic structure (400).

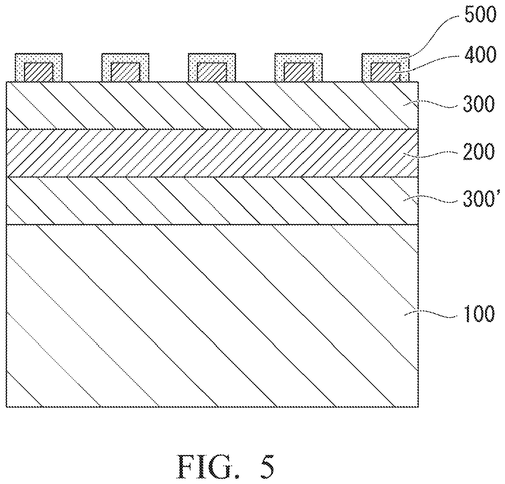

As shown in Figure 5, it is preferable to combine the multi-layered structure with three layers and the periodic structure layer with the second material between the first materials (500). By employing this combination, transmission light with narrower full width at half maximum can be obtained.

### <Substrate>

The wavelength selective filter according to the present embodiment may be arranged on a substrate (100). The substrate (100) may be made of any material. The substrate (100) is preferably made of inorganic material and is more preferably made of semiconductor or glass. For example, the substrate (100) may be a glass substrate.

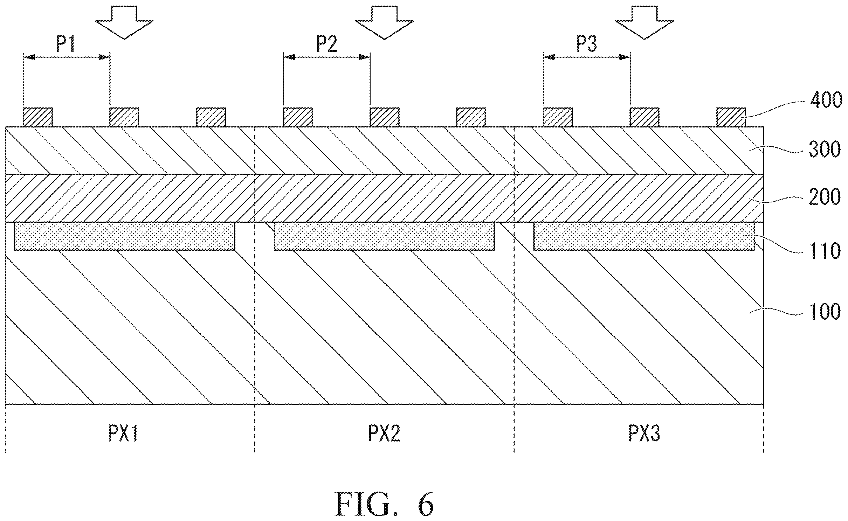

The wavelength selective filter according to the present embodiment may comprise an image sensor between the substrate (100) and the multi-layered structure to detect the transmission light. Figure 6 shows a cross sectional schematic diagram of a wavelength selective filter according to an example with an image sensor (110) between the substrate (100) and the multi-layered structure. The wavelength selective filter shown in Figure 6 has three areas (PX1, PX2, PX3), and the periodic structure (400) has different arrangement pitch (P1, P2, P3) in each of the areas. Therefore, each area (PX1, PX2, PX3) selectively passes a different wavelength. The image sensor (110) arranged in each area detects light with different wavelength, and accordingly, the sensor of Figure 6 works as a spectroscopic sensor or a hyperspectral imaging camera.

Any kind of image sensor may be used as the image sensor (110). For example, an Si substrate may be used as the substrate (100) and a CMOS (Complementary Metal-Oxide-Semiconductor) image sensor may be used as the image sensor (110). The sensitivity of the sensor can be improved by employing a larger CMOS sensor structure in each area (PX1, PX2, PX3).

### [Optical Property of the Wavelength Selective Filter]

The wavelength selective filter according to the present embodiment may have a peak wavelength in a near infrared wavelength region. Specifically, the peak wavelength preferably lies within a range between 750 nm and 1050 nm. The wavelength selective filter according to the present embodiment can have narrow full width at half maximum. Specifically, the full width at half maximum (FWHM) of the transmittance distribution to the peak wavelength of the transmission light may be 100 nm or less, is preferably 50 nm or less, and is more preferably 30 nm or less.

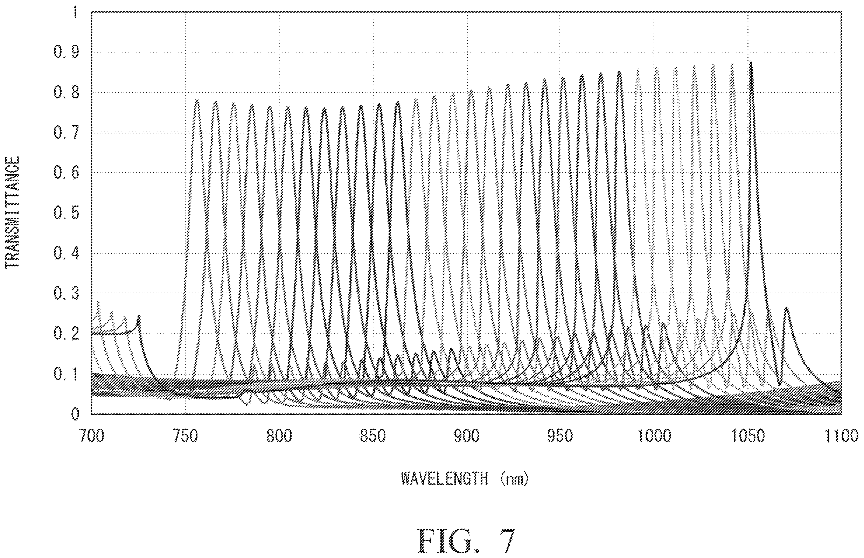

Figure 7 shows a simulation results calculated using a Rigorous Coupled Wave Analysis (RCWA) method of the transmission light of the wavelength selective filter according to the configuration described in Figure 5. The RCWA method is one of the accurate electromagnetic field analysis methods. The simulation conditions are as follows: the substrate (100) is a glass substrate; the low refractive index layers (300, 300') are SiO2 layers with a thickness of 180 nm; the high refractive index layer (200) is a HfO2 layer with a thickness of 80 nm; the periodic structure (400) is composed of a plurality of square island structures with a thickness of 30 nm that are arranged spaced apart in a grid pattern; the periodic structure (400) is made of aluminium; the layer made of the first material (500) is an SiO2 layer with a thickness of 30 nm; and the second material is air. In addition, the width (A) of the structural object is set to 0.75 times of the arrangement pitch (P) of the structural object. Then, optical properties of wavelength selective filters have been calculated by changing the arrangement pitch (P) from 510 nm to 733.5 nm in 7.5 nm increments. Referring to Figure 7, you can see that the peak wavelength covers the range of 750 nm to 1050 nm and that the wavelength resolution of 10 nm and the transmittance of 80% have been achieved. Therefore, the wavelength selective filter according to the aforementioned configuration is expected to have a peak wavelength in a near infrared wavelength region and to have a narrower full width at half maximum of the transmission light than a conventional filter.

### [Method for Fabricating the Wavelength Selective Filter]

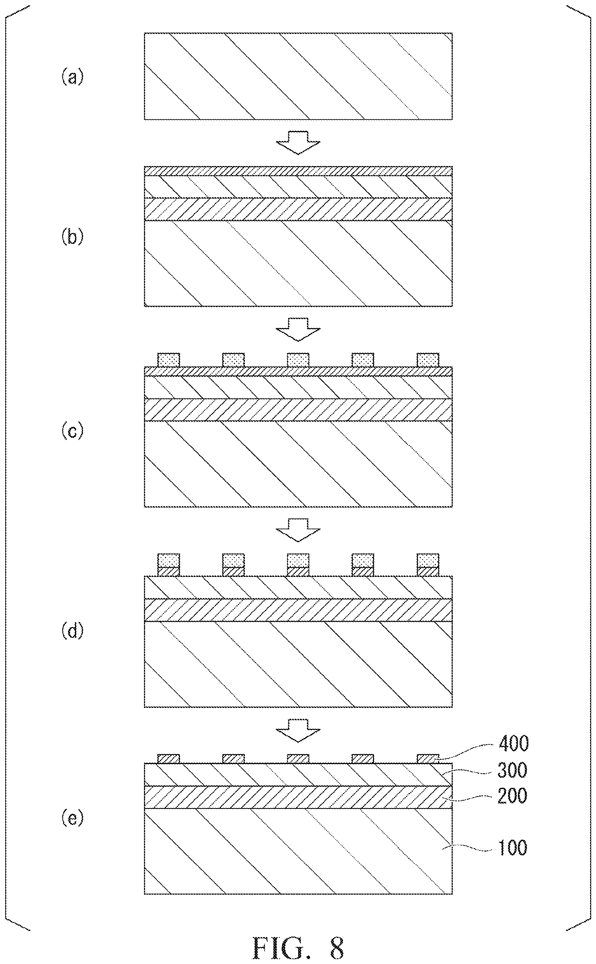

A method for fabricating the wavelength selective filter according to the present embodiment comprises steps of: alternately depositing the low refractive index layer (300) and the high refractive index layer (200) to form the multi-layered structure; depositing a layer of the metal or the semiconductor; and patterning the layer of the metal or the semiconductor to form the periodic structure (400). Fabrication flow of the wavelength selective filter according to the present embodiment is shown in Figure 8.

In step (a) of Figure 8, the substrate (100) may be provided. During this step, the image sensor (110) may be formed on the substrate (100). This step may include a step of cleaning the substrate (100) and/or planarizing the surface of the substrate (100). The cleaning and the planarization of the substrate (100) may be conducted through any process known in the art.

Next, in step (b) of Figure 8, the low refractive index layer (300) and the high refractive index layer (200) are alternately deposited to form the multi-layered structure, and a layer of the metal or the semiconductor is deposited such that layer of the metal or the semiconductor faces the low refractive index layer (300). The low refractive index layer (300), the high refractive index layer (200), and the layer of the metal or the semiconductor may be deposited through any process and, for example, they may be deposited by chemical vapour deposition (CVD) or physical vapour deposition (PVD). A sputtering method can be used as the physical vapour deposition.

Next, in steps (c) to (e) of Figure 8, the layer of the metal or the semiconductor is patterned to form the periodic structure (400). Metal mask technology, lithography technology using light or electron beam, or nanoimprint technology can be used as the patterning method. For example, resist film pattern is formed using electron beam lithography on a part of the layer of the metal or the semiconductor that should remain as the periodic structure (400) (Figure 8 (c)).

Then, a part of the layer of the metal or the semiconductor that are not covered with the resist film pattern is removed by etching (Figure 8 (d)). Any known method may be used as the etching method. The etching may be dry etching or wet etching. For example, the etching may be dry etching using chlorine-based gas. When etching the layer of the metal or the semiconductor, the low refractive index layer (300) may be overetched. The degree of the overetching is preferably 30 nm or less and more preferably 10 nm or less.

Then, the resist film pattern is removed (Figure 8 (e)). The resist film pattern may be removed by any method, and is preferably removed by a treatment using organic solvent or by a treatment using plasma. For example, the resist film pattern may be removed by plasma treatment using an oxygen-containing gas. The periodic structure (400) can be formed in this manner.

The method for fabricating the wavelength selective filter according to the present embodiment may comprise a step of depositing the first material (500) having a refractive index between 1.30 and 1.60 after the periodic structure (400) is formed. The first material (500) may be deposited through any process and, for example, the first material (500) may be deposited by chemical vapour deposition (CVD) or physical vapour deposition (PVD). A sputtering method can be used as the physical vapour deposition. After depositing the first material (500), a planarization treatment or patterning may be performed if needed to obtain a layer made of the first material (500). The planarization treatment can be performed by chemical machine polishing (CMP), for example.

For example, the layer made of the first material (500) according to the example shown in Figure 3 can be obtained by performing the planarization treatment after depositing the first material (500) thickly enough. In addition, the layer made of the first material (500) according to the embodiment shown in Figure 4 can be obtained by depositing the layer made of the first material (500) with a desired thickness after the periodic structure (400) is formed.

The method for fabricating the wavelength selective filter according to the present embodiment may comprise a step of depositing the second material and planarizing the deposited second material after the layer made of the first material (500) is formed. If the second material is gaseous matter such as air, the step of depositing the second material is not necessary. If the second material is gaseous matter, the first material (500) may be patterned to adjust the position where the gaseous matter exists.

The method for fabricating the wavelength selective filter according to the present embodiment may comprise a step of forming an on-chip lens. The on-chip lens is preferably formed on the layer made of the first material (500) that has been planarized. The on-chip lens may be formed by any known method.

### [Examples]

Hereinafter, the present disclosure is explained in detail while showing examples, however, the present disclosure is not limited to the examples as long as the effects of the present disclosure is realized.

### [Fabrication of the Wavelength Selective Filter]

### <Example 1>

A glass substrate was used as the substrate. Hafnium oxide (HfO2) was deposited on the glass substrate by sputtering to form a high refractive index layer. The thickness of the high refractive index layer was 80 nm. Then, silicon dioxide (SiO2) was deposited on the high refractive index layer by sputtering to form a low refractive index layer. The thickness of the low refractive index layer was 180 nm. Then, metal aluminium (Al) was deposited on the low refractive index layer by sputtering. The thickness of the deposited aluminium thin film was 30 nm. The aluminium thin film was patterned by electron beam lithography to form a periodic structure composed of a plurality of square island structures that are made of aluminium and arranged spaced apart in a grid pattern. The square island structure was square in planar view. The arrangement pitch of the square island structure was 510 nm and the length (width) of one side of the square island structure was 0.75 times of the arrangement pitch.

### <Example 2>

A wavelength selective filter was fabricated in the same manner as Example 1 except that the arrangement pitch of the square island structure was changed to 532.5 nm.

### <Example 3>

A wavelength selective filter was fabricated in the same manner as Example 1 except that the arrangement pitch of the square island structure was changed to 555 nm.

### <Example 4>

A wavelength selective filter was fabricated in the same manner as Example 1 except that the arrangement pitch of the square island structure was changed to 577.5 nm.

### <Example 5>

A wavelength selective filter was fabricated in the same manner as Example 1 except that the arrangement pitch of the square island structure was changed to 600 nm.

### [Evaluation of the Wavelength Selective Filters]

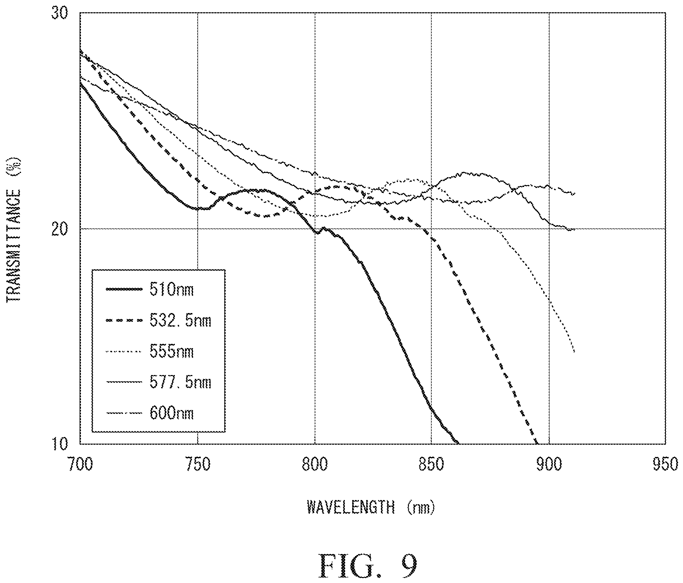

The transmittance of the wavelength selective filters fabricated in Examples 1 to 5 was measured by a transmittance measuring device (LVmicro-Z by Lambda Vision Incorporated). The measurement results were shown in Figure 9. Referring to Figure 9, you can see that the peak wavelength of the transmission light shifted from around 770 nm to around 870 nm by changing the arrangement pitch of the periodic structure from 510 nm to 600 nm. Thus, the wavelength selective filters according to Examples 1 to 5 have a peak wavelength in a near infrared wavelength region.

In addition, the full width at half maximums of the transmission lights of the wavelength selective filters according to Examples 1 to 5 were around 30 nm to 40 nm. Thus, the transmission light of Examples 1 to 5 had narrower full width at half maximums than the wavelength selective filters using surface plasmon resonance according to the prior art.

### [Description of the Reference Numerals]

100: substrate
200: high refractive index layer
300, 300': low refractive index layer
400: periodic structure
500: first material

## Claims

1. A wavelength selective filter comprising:
a multi-layered structure alternately having a low refractive index layer (300, 300') and a high refractive index layer (200),
a periodic structure layer (400) facing the low refractive index layer (300, 300') of the multi-layered structure,
the low refractive index layer (300, 300') having a refractive index between 1.30 and 1.60 and a thickness between 100 nm and 800 nm,
the high refractive index layer (200) having a refractive index between 1.70 and 2.20 and a thickness between 30 nm and 100 nm, and
in a plane perpendicular to a thickness direction of the periodic structure layer (400), the periodic structure layer (400) having a periodic structure made of metal or semiconductor,
**characterized in that,**
in the plane perpendicular to the thickness direction of the periodic structure layer (400), the periodic structure is surrounded by first material (500) having a refractive index between 1.30 and 1.60,
wherein in the plane perpendicular to the thickness direction of the periodic structure layer (400), the wavelength selective filter has second material between two neighbouring first materials (500), and wherein the second material has a refractive index between 1.00 and 1.20.

2. The wavelength selective filter of claim 1, wherein the multi-layered structure is a three-layered structure consisting of two low refractive index layers (300, 300') and one high refractive index layer (200) positioned between the two low refractive index layers (300, 300').

3. The wavelength selective filter of any one of claims 1 and 2, wherein the periodic structure is composed of a plurality of square island structures that are arranged spaced apart in a grid pattern, and
wherein width of one side of the square island structure is between 65% and 85% of an arrangement pitch of the square island structure.

4. A method for fabricating the wavelength selective filter of any one of claims 1 to 3, the method comprising steps of:
alternately depositing the low refractive index layer (300, 300') and the high refractive index layer (200) to form the multi-layered structure,
depositing a layer of the metal or the semiconductor,
patterning the layer of the metal or the semiconductor to form the periodic structure, and
depositing the layer made of the first material (500) with a desired thickness.

## Patentansprüche

1. Wellenlängenselektiver Filter, der umfasst:
eine mehrschichtige Struktur, die abwechselnd eine Schicht (300, 300') mit niedrigem Brechungsindex und eine Schicht (200) mit hohem Brechungsindex aufweist,
eine periodische Strukturschicht (400), die der Schicht (300, 300') mit niedrigem Brechungsindex der mehrschichtigen Struktur zugewandt ist,
wobei die Schicht (300, 300') mit niedrigem Brechungsindex einen Brechungsindex zwischen 1,30 und 1,60 und eine Dicke zwischen 100 nm und 800 nm aufweist,
wobei die Schicht (200) mit hohem Brechungsindex einen Brechungsindex zwischen 1,70 und 2,20 und eine Dicke zwischen 30 nm und 100 nm aufweist, und
wobei in einer Ebene senkrecht zu einer Dickenrichtung der periodischen Strukturschicht (400), die periodische Strukturschicht (400) eine periodische Struktur aufweist, die aus Metall oder Halbleiter hergestellt ist,
**dadurch gekennzeichnet, dass**
in der Ebene senkrecht zu der Dickenrichtung der periodischen Strukturschicht (400), die periodische Struktur durch ein erstes Material (500) umgeben ist, das einen Brechungsindex zwischen 1,30 und 1,60 aufweist,
wobei in der Ebene senkrecht zu der Dickenrichtung der periodischen Strukturschicht (400), der wellenlängenselektive Filter ein zweites Material zwischen zwei angrenzenden ersten Materialien (500) aufweist, und wobei das zweite Material einen Brechungsindex zwischen 1,00 und 1,20 aufweist.

2. Wellenlängenselektiver Filter nach Anspruch 1, wobei die mehrschichtige Struktur eine dreischichtige Struktur ist, die aus zwei Schichten (300, 300') mit niedrigem Brechungsindex und einer Schicht (200) mit hohem Brechungsindex besteht, die zwischen den zwei Schichten (300, 300') mit niedrigem Brechungsindex positioniert ist.

3. Wellenlängenselektiver Filter nach einem der Ansprüche 1 und 2, wobei die periodische Struktur aus einer Vielzahl von quadratischen Inselstrukturen besteht, die in einem Gittermuster beabstandet angeordnet sind, und
wobei eine Breite einer Seite der quadratischen Inselstruktur zwischen 65 % und 85 % eines Anordnungsabstands der quadratischen Inselstruktur beträgt.

4. Verfahren für ein Produzieren des wellenlängenselektiven Filters nach einem der Ansprüche 1 bis 3, wobei das Verfahren die Schritte umfasst:
abwechselndes Abscheiden der Schicht (300, 300') mit niedrigem Brechungsindex und
der Schicht (200) mit hohem Brechungsindex, um die mehrschichtige Struktur auszubilden,
Abscheiden einer Schicht des Metalls oder des Halbleiters,
Mustergeben der Schicht des Metalls oder des Halbleiters, um die periodische Struktur auszubilden, und
Abscheiden der Schicht, die aus dem ersten Material (500) hergestellt ist, mit einer gewünschten Dicke.

## Revendications

1. Filtre à sélection de longueur d'onde comprenant :
une structure multicouche ayant alternativement une couche à faible indice de réfraction (300, 300') et une couche à indice de réfraction élevé (200),
une couche de structure périodique (400) faisant face à la couche à faible indice de réfraction (300, 300') de la structure multicouche,
la couche à faible indice de réfraction (300, 300') ayant un indice de réfraction compris entre 1,30 et 1,60 et une épaisseur comprise entre 100 nm et 800 nm,
la couche à indice de réfraction élevé (200) ayant un indice de réfraction compris entre 1,70 et 2,20 et une épaisseur comprise entre 30 nm et 100 nm, et
dans un plan perpendiculaire à la direction de l'épaisseur de la couche de structure périodique (400), la couche de structure périodique (400) ayant une structure périodique constituée de métal ou de semi-conducteurs,
**caractérisé en ce que**,
dans le plan perpendiculaire à la direction de l'épaisseur de la couche de structure périodique (400), la structure périodique est entourée d'un premier matériau (500) ayant un indice de réfraction compris entre 1,30 et 1,60,
dans lequel, dans le plan perpendiculaire à la direction de l'épaisseur de la couche de structure périodique (400), le filtre à sélection de longueur d'onde a un second matériau entre deux premiers matériaux voisins (500), et dans lequel le second matériau a un indice de réfraction compris entre 1,00 et 1,20.

2. Filtre à sélection de longueur d'onde selon la revendication 1, dans lequel la structure multicouche est une structure à trois couches composée de deux couches à faible indice de réfraction (300, 300') et d'une couche à indice de réfraction élevé (200) placée entre les deux couches à faible indice de réfraction (300, 300').

3. Filtre à sélection de longueur d'onde selon l'une des revendications 1 et 2, dans lequel la structure périodique est composée d'une pluralité de structures en îlots carrés qui sont agencées à distance les unes des autres selon un modèle de grille, et
dans lequel la largeur d'un côté de la structure en îlot carré est comprise entre 65 % et 85 % du pas d'agencement de la structure en îlot carré.

4. Procédé de fabrication du filtre à sélection de longueur d'onde selon l'une quelconque des revendications 1 à 3, comprenant les étapes consistant à :
déposer alternativement la couche à faible indice de réfraction (300, 300') et la couche à indice de réfraction élevé (200) pour former la structure multicouche,
déposer une couche de métal ou de semi-conducteurs,
modéliser la couche de métal ou de semi-conducteurs pour former la structure périodique, et
déposer la couche constituée du premier matériau (500) avec une épaisseur souhaitée.
